# EUROPÄISCHE PATENTSCHRIFT

(11) **EP 2 942 812 B1**
(45) Veröffentlichungstag und Bekanntmachung des Hinweises auf die Patenterteilung: **05.09.2018**
(21) Anmeldenummer: 15001242.5
(22) Anmeldetag: 27.04.2015
(51) Int. Cl.: H01L 27/146

(54) **DETEKTORANORDNUNG UND ENTSPRECHENDES BETRIEBSVERFAHREN**
DETECTOR ASSEMBLY AND CORRESPONDING OPERATING METHOD
SYSTÈME DE DÉTECTION ET PROCÉDÉ DE FONCTIONNEMENT CORRESPONDANT

(30) Priorität: 07.05.2014 DE 102014006648
(43) Veröffentlichungstag der Anmeldung: 11.11.2015
(73) Patentinhaber: Max-Planck-Gesellschaft zur Förderung der Wissenschaften e.V., 80539 München (DE)
(72) Erfinder: Bähr, Alexander, 82194 Gröbenzell (DE); Richter, Rainer, 81243 München (DE); Schopper, Florian, 80802 München (DE); Treis, Johannes, 81669 München (DE)
(74) Vertreter: v. Bezold & Partner Patentanwälte - PartG mbB

(56) Entgegenhaltungen:
- EP-B1- 1 873 834
- DE-A1-102011 115 656
- DE-B3-102007 017 640
- DE-B3-102011 113 767
- GERHARD LUTZ ET AL: "DEPFET detector-amplifier structure: Properties, achievements and new developments, concepts and applications", NUCLEAR SCIENCE SYMPOSIUM CONFERENCE RECORD, 2007. NSS '07. IEEE, IEEE, PI, 1. Oktober 2007 (2007-10-01), Seiten 988-994, XP031206646, ISBN: 978-1-4244-0922-8
- ULRICI J ET AL: "Spectroscopic and imaging performance of DEPFET pixel sensors", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, Bd. 465, Nr. 1, 1. Juni 2001 (2001-06-01), Seiten 247-252, XP004246811, ISSN: 0168-9002, DOI: 10.1016/S0168-9002(01)00401-6

## Beschreibung

### Gebiet der Erfindung

Die Erfindung betrifft eine Detektoranordnung zur Detektion von Strahlung, insbesondere von Teilchenstrahlung oder elektromagnetischer Strahlung.

### Hintergrund der Erfindung

Immer, wenn bildgebende Sensoren zur quantitativen Analyse einfallender Strahlung eingesetzt werden, ist die präzise Kontrolle der Belichtungszeit, also der Zeit, während derer der Sensor der einfallenden Strahlung ausgesetzt ist, von wesentlicher Bedeutung. Die Belichtung des Sensors muss hierbei entweder möglichst homogen über seine Fläche erfolgen, oder die durch den Verschluss erzeugten Inhomogenitäten müssen so genau bekannt sein, dass eine nachträgliche Kalibrierung erfolgen kann.

In vielen Bereichen, bei denen es nicht auf hohe Geschwindigkeiten ankommt, werden mechanische Verschlüsse eingesetzt. Diese weisen allerdings nicht beliebig kurze Verschlusszeiten oder beliebig hohe Wiederholraten auf, und ihre Lebensdauer ist aufgrund des mechanischen Verschleißes begrenzt. Elektrooptische Verschlusselemente wie zum Beispiel akustooptische Modulatoren weisen zwar deutlich schnelleres Zeitverhalten auf, allerdings sind sie als Vorsatzgeräte mit separater Ansteuerung wenig kompakt und daher nicht für alle Anwendungen geeignet. Ähnliches gilt für ansteuerbare Bildverstärkerröhren.

Neue Entwicklungen im Bereich bildgebender Sensoren erlauben allerdings eine Integration des Verschlusses in den Sensor selbst in Form eines "elektronischen" Verschlusses: Die Strahlung wird nicht mehr physikalisch von der Sensoroberfläche fern gehalten, sondern das Signal auf dem Sensor selbst entweder registriert oder verworfen.

Eine solche elektronische Verschlussschaltung lässt sich allerdings nicht für jeden Typ bildgebender Sensoren umsetzen. Für CCD-basierte (CCD: Charge-coupled Device) Sensoren z.B. ist ein solcher Mechanismus nicht umsetzbar. Hier wird sich mit lokalen Zwischenspeichern beholfen, die allerdings nur endliche Speichertiefe aufweisen und zudem einen Verlust an Sensitivität bedingen.

Konzepte auf der Basis von sogenannten aktiven Pixelsensoren (APS: Active Pixel Sensor) hingegen sind schon in der breiten Anwendung. Je nach Umsetzung ist ein solcher elektronischer Verschluss mit sehr hohen Taktraten und sehr guter Homogenität über den sensitiven Bereich des entsprechenden Sensors schaltbar.

Allerdings haben die im Augenblick verwendeten Konzepte zur Umsetzung eines elektronischen Verschlusses mit den vorher erwähnten Konzepten mechanischer oder elektrooptischer Natur gemeinsam, dass der Sensor außerhalb der Öffnungszeit des Verschlusses vollständig insensitiv ist. Der Verschluss führt also zu einer Totzeit des Sensors. Dies ist immer dann ein Problem, wenn zeit-kontinuierlich gemessen werden soll, d.h. direkt ohne Totzeit aufeinander folgende Bilder mit definierter Belichtungszeit aufgenommen werden müssen.

Ein Verschlussmechanismus kann aber auch eine weitere, über die Steuerung der Belichtungszeit hinausgehende Funktion übernehmen. Durch ihn lässt es sich verhindern, dass während des Ausleseprozesses eintreffende Signale die Signalauswertung stören und die Signale verfälschen.

Das vom eigentlichen Sensor während der Belichtungszeit erfasste Signal muss zur Weiterverarbeitung aus dem Sensor extrahiert, dann verstärkt und digitalisiert werden. In Abhängigkeit von der geforderten Genauigkeit sind entsprechend längere Prozessierungszeiten erforderlich. Treffen neue Signale während der Prozessierung des bereits vorhandenen Signals ein, wird die Signalamplitude verfälscht. Art und Ausmaß der zu erwartenden Verfälschung hängen hierbei sehr stark vom verwendeten Sensor ab.

Bei CCDs zum Beispiel gibt es eine Aufteilung des Arbeitszyklus in Belichtungszeit und Transferzeit. Während der Belichtungszeit werden durch einfallende Photonen generierte Ladungen integriert. Während der Transferzeit wird die Signalladung zum Ausleseverstärker transferiert und ggf. dort verstärkt. Für zeitkritische Anwendungen wird das CCD spaltenparallel ausgelesen, d.h. jede CCD-Spalte verfügt über einen eigenen Verstärkerkanal, wodurch sich die Auslesegeschwindigkeit in etwa mit der Anzahl der Spalten multipliziert. Trotzdem können die während des Ladungstransfers im Sensor eintreffenden zusätzlichen Signale weder in der Zeit noch in der Position korrekt zugeordnet werden. Dies sind die sogenannten Out-Of-Time-Events (OOT).

Durch die erwähnten langen Signalprozessierungszeiten wird die Gesamtauslesezeit nicht allein durch den reinen Ladungstransfer, sondern ganz wesentlich durch die Signalprozessierung bestimmt. Deshalb versucht man, die Transferzeit von der Signalprozessierungszeit zu entkoppeln, indem man durch Verdopplung der Pixelanzahl einen Zwischenspeicher schafft (Frame Store). Jetzt hat man einen Sensorbereich und einen Frame-Store-Bereich. Die Signalladung wird (schnell) vom Sensorbereich in den Frame-Store-Bereich transferiert und kann von dort (langsam) zu den am Matrixende angeordneten Verstärkern geschoben und verstärkt werden, während im Sensorbereich schon wieder Ladung integriert wird.

Mit dieser aufwändigen Maßnahme wird die Anzahl der OOTs zwar deutlich reduziert, man kann sie aber aufgrund der endlichen Transferzeit zwischen Sensor- und Frame-Store-Bereich nicht gänzlich unterdrücken. Außerdem ist man auch in diesem Falle nicht frei in der Wahl der Integrationszeit, da die Integrationszeit mindestens so lang wie die Auslesezeit sein muss. Die Implementation eines elektronischen Verschlusses in das CCD ist konzeptionell nicht möglich. Ein externer Verschluss kann auftretende OOTs vollständig unterdrücken, führt jedoch auch wieder eine Totzeit ein.

Wie schon erwähnt, muss bei einem CCD der notwendige Transfer der Signalladung - und zwar der gesamten im Sensorbereich gesammelten - zum Ausleseknoten im ungünstigsten Fall über die gesamte Sensor- (und Frame-Store-) Länge erfolgen. Dies stellt einen substanziellen Nachteil des CCDs dar. Ein echter Window-Modus etwa, im Sinne eines schnellen wahlfreien Zugriffs auf eine sogenannte Region-Of-Interest (ROI), ist deshalb nicht möglich. Das ist der große Vorteil eines 'echten' aktiven Pixeldetektors, bei dem die Signalladung am Ort ihrer Erzeugung gesammelt und verstärkt wird. Ein Transfer von Signalladungen entfällt hierbei, und durch entsprechende Verschaltung und Ansteuerung der Pixel (Bildpunkte) können beliebige Regionen ausgewählt und sogar mit höherer Rate wiederholt ausgelesen werden. Ein Beispiel für die Implementation dieses Konzepts ist eine aus DEPFETs (DEPFET: Depleted Field Effect Transistor) bestehende Sensormatrix. Je nach Größe der ROI ist lokal eine Vervielfachung der Auslesegeschwindigkeit gegenüber der gesamten Matrix möglich. Die Verwendung von aktiven Pixelsensoren hat jedoch auch Nachteile. Dazu gehören, vor allem beim DEPFET, fehlerhafte Signalerfassung durch die permanente Sensitivität (s.u.), genauso wie die sogenannten "Rolling Shutter"-Effekte. Diese werden durch den zeitlichen Versatz bei der Auslese unterschiedlicher Zeilen (und damit ihrer Integrationszeit) hervorgerufen, und können, vor allem bei schnell bewegten Objekten, zu Artefakten und Bildverzerrungen führen.

Da die in das Pixel integrierte verstärkende Elektronik innerhalb des Sensorbereichs liegt, wirken sich während der Prozessierung eintreffende Signalladungen anders aus als beim CCD. Wie beschrieben, werden solche Ereignisse beim CCD in Ort und Zeit falsch zugeordnet. Beim DEPFET werden die zu einem beliebigen Zeitpunkt während des Auslesezyklus eintreffenden Ladungsträger falsch gewichtet und verfälschen somit die erfasste Signalamplitude. Der DEPFET ermittelt das Signal durch Differenzbildung der Ströme im Transistor des aktiven Pixels vor (Signalstrom) und nach einem Löschpuls (Referenzstrom).

Erreichen die Signalladungen nach dem Löschen das interne Gate des DEPFET, wird der Wert des Initialstroms verfälscht, was im Extremfall sogar zu paradoxen "negativen" Signalamplituden führen kann.

Noch problematischer für die Anwendung sind allerdings Ladungen, die vor dem Löschen das interne Gate des DEPFET erreichen, da diese unvollständig verstärkt werden. Solche Ereignisse sind vor allem für spektroskopische Anwendungen sehr problematisch, da die verfälschten Signalamplituden als irreduzibler Untergrund im Spektrum auftauchen.

Derartige Signalverfälschungen werden im Fachjargon "Misfits" genannt. Ihrer Natur gemäß treten sie vor allem bei der Beobachtung zeitlich unkorrelierter Strahlung auf, z.B. bei astronomischen Beobachtungen oder optischer Bildgebung, da hier die Auslese des Sensors nicht mit dem Eintreffen der Strahlung synchronisiert werden kann. Der Anteil von Misfits an den Gesamtereignissen entspricht hierbei dem Verhältnis zwischen der Signalprozessierungszeit und der Integrationszeit. Anwendungen, in denen die Signalrate hoch ist, sind daher überproportional von dem Problem betroffen, da erstens die Gesamtzahl von "Misfit"-Ereignissen mit der Signalrate ansteigt, und zweitens die hohe Signalrate eine Erhöhung der Bildrate, d.h. eine Verkürzung der Integrationszeit, bei ansonsten unveränderter Signalprozessierungszeit erfordert.

Auch eine Beschleunigung der Auslese durch Parallelisierung, indem z.B. mehrere Zeilen einer Matrix gleichzeitig ausgelesen werden, verschlimmert das Problem, da der Anteil an Misfits proportional zur Anzahl der gleichzeitig ausgelesenen Pixel weiter zunimmt. Der vom Standpunkt des Experimentators sinnvolle Extremfall eines hybriden DEPFET-Pixelsensors, der vollparallel ausgelesen wird, ist somit unter dem Gesichtspunkt der spektralen Verwertbarkeit der Daten am ungünstigsten.

Dieses Problem wird durch die permanente Sensitivität des Pixels auch während der Auslesephase verursacht. Daher besteht eine Lösung darin, das Pixel während des Auslesens insensitiv zu schalten. Das Konzept des DEPFETs erlaubt es, einen konventionellen elektronischen Verschluss zu integrieren. In EP 1 873 834 B1 z.B. wird eine DEPFET-Struktur vorgeschlagen, bei der der Detektor während eines definierbaren Zeitfensters insensitiv geschaltet werden kann, indem die eintreffenden Elektronen vom Löschkontakt abgesaugt werden. Durch eine zusätzliche, das interne Gate des DEPFET umschließende Elektrode wird hierbei verhindert, dass die dort schon gespeicherten Elektronen ebenfalls abgesaugt werden. Dieser elektronische Verschluss eröffnet nicht nur die Möglichkeit, die Belichtung des Sensors mit einer Genauigkeit im Mikrosekunden-Bereich zu steuern. Die DEPFET-Pixel können darüber hinaus auch während des Auslesens insensitiv gemacht werden gegenüber Störsignalen, wie Streulicht, thermisch generierten Elektronen oder auch Signalelektronen, die zu Misfits führen würden.

Allerdings ist diese Option mit einer Totzeit des gesamten Sensors verbunden, die der gesamten Auslesezeit entspricht. Alle Signalelektronen, die eintreffen, während der Shutter geschlossen ist, sind unwiderruflich verloren. Eine zeilenweise Verschaltung des Shutters verringert die Totzeit zwar auf die Auslesezeit einer Zeile, allerdings geht dadurch auch die Eigenschaft des globalen Verschlusses verloren.

Einige Anwendungen, wie z.B. die Polarimetrie, stellen über die reine abschirmende Wirkung hinaus noch weitere Anforderungen an den elektronischen Verschluss. Eine häufig verwendete Technik der Polarimetrie beruht auf der Erfassung der sog. Stokes-Parameter. Hierbei werden separate Bilder aufgenommen, während sich Polarisationsfilter in unterschiedlichen Positionen (typischerweise 4) befinden. Da das Polarisationssignal aus der Differenz der Bilder zweier Filterpositionen besteht, verschwindet der unpolarisierte Anteil des Lichts, soweit er sich während der beiden Aufnahmen nicht ändert. Oft ist es jedoch unvermeidbar, dass das Licht auf dem Weg zwischen Quelle und Detektor gestört wird. So wird es bei astronomischen Beobachtungen durch Turbulenzen in den oberen Atmosphärenschichten verfälscht. Für die Polarimetrie z.B. sind besonders Schwankungen des unpolarisierten Anteils mit Frequenzen um oder oberhalb der Ausleserate problematisch, da der unpolarisierte Anteil um viele Größenordnungen stärker ist als der polarisierte. Um den Effekt solcher Schwankungen zu unterdrücken, soll daher die Polarisationsebene in möglichst kurzen Zeitabständen getauscht und das jeweils zugehörige Bild erfasst werden.

Für diese Untersuchungen werden üblicherweise CCD-basierende Sensoren verwendet. Einige Instrumente verwenden Framestore-CCDs, die mit möglichst hoher Bildrate betrieben werden. Für jede Einstellung des Polarisators wird ein separates Bild mittels des CCDs aufgenommen. Der Nachteil von Framestore-CCDs besteht darin, dass die Polarisation nicht schneller verändert werden kann, als die Auslesegeschwindigkeit des CCDs. Zudem müssen die OOT bedingten Fehler während des Verschiebens in den Framestore iterativ korrigiert werden. Alternativ werden spezielle CCDs verwendet, bei denen streifenweise Zeilen (typischerweise 4) abgedeckt sind, in welchen die Bilder der einzelnen (meist 4) Polarisatorstellungen gesammelt werden. Jede Polarisatorstellung ist hierbei einer Zeile zugeordnet, und die Signale mehrerer Zyklen werden in der jeweiligen Zeile aufsummiert, bevor der Frame ausgelesen wird. Der Nachteil von CCDs mit abgedeckten Spalten besteht darin, dass ein signifikanter Teil der Quanteneffizienz verloren geht und während des Auslesens dieselben Fehler wie bei Framestore-CCDs auftreten, solange der CCD nicht anders (z.B. mechanisch) abgedunkelt wird. Außerdem sind beide Methoden mit einer signifikanten Totzeit verbunden, und die maximale Bildrate bleibt an die Auslesegeschwindigkeit gekoppelt. Nachteilig an den bekannten Detektoranordnungen sind also die Totzeiten, in denen die einfallende Strahlung nicht erfasst wird, oder alternativ die durch die permanente Sensitivität im Signal erzeugten Artefakte.

Ferner wird zum Stand der Technik hingewiesen auf DE 10 2007 017640 B3, DE 10 2011 115656 A1 und GERHARD LUTZ ET AL: "DEPFET detector-amplifier structure: Properties, achievements and new developments, concepts and applications", NUCLEAR SCIENCE SYMPOSIUM CONFERENCE RECORD, 2007. NSS'07.IEEE, IEEE, PI, 1. Oktober 2007 (2007-10-01), Seiten 988-994, XP031206646, ISBN: 978-1-4244-0922-8. Teilweise offenbaren diese Druckschriften matrixförmige Pixelanordnungen. Teilweise offenbaren diese Druckschriften auch Detektoranordnungen ohne eine Ortsauflösung, d. h. ohne eine Unterteilung in Pixel.

### Aufgabe der Erfindung

Die Aufgabe der Erfindung ist es, eine Detektoranordnung mit einem elektronischen Verschluss zu schaffen, welche die Totzeiten bei der Bilderfassung minimiert. Außerdem sollen Teilbilder erfasst werden können, d.h. Signalelektronen sollen in unterschiedlichen Zeiträumen in individuell zugeordneten Speichern innerhalb einer Bildzelle gesammelt werden können. Für den Fall periodisch wiederkehrender Beobachtungsbedingungen soll eine Summation der erfassten Signale direkt in dem jeweiligen Speicher möglich sein.

### Wesen der Erfindung

Diese Aufgabe wird durch eine Detektoranordnung gemäß dem Hauptanspruch gelöst.

Hierbei ist zu erwähnen, dass die Erfindung hinsichtlich der Anzahl der Subpixel pro Pixel nicht beschränkt ist auf zwei Subpixel pro Pixel. Beispielsweise kann jedes Pixel auch vier Subpixel aufweisen oder eine andere Anzahl von Subpixeln. Die einzelnen Pixel weisen also allenfalls beim Löschen der angesammelten Signalladungsträger eine Totzeit auf, in der keine Strahlung gemessen wird. Ansonsten sind die Pixel dagegen totzeitfrei, da immer eines der Subpixel sensitiv ist. Jedes Subpixel weist als Ausleseelement jeweils einen DEPFET auf. Bei einem DEPFET als Ausleseelement in den Subpixeln wird im insensitiven Zustand durch Potenzialbarrieren verhindert, dass strahlungsgenerierte Signalladungsträger in das interne Gate des insensitiv geschalteten Subpixel gelangen. Die Potenzialbarrieren sorgen also dafür, dass strahlungsgenerierte Signalladungsträger mit einer hohen Selektivität nahezu ausschließlich in das interne Gate des DEPFETs in dem sensitiv geschalteten Subpixel gelangen, während das interne Gate des DEPFETs in dem sensitiv geschalteten Subpixel durch die Potenzialbarrieren abgeschirmt wird.

Die DEPFETs der einzelnen Subpixel sind vorzugsweise umschaltbar zwischen einem Auslesebetrieb und einem Nicht-Auslese-Betrieb, wobei die in dem internen Gate angesammelten Signalladungsträger im Auslesebetrieb ein Ausgangssignal erzeugen, das die gemessene Strahlung wiedergibt, wohingegen im Nicht-Auslesebetrieb kein Signal ausgelesen wird.

Die Potenzialbarrieren zum Abschirmen des insensitiv geschalteten Subpixels gehen von Schirmelektroden innerhalb des Gebietes des insensitiven Subpixels aus und erstrecken sich in Richtung des Source-Gebietes des insensitiven DEPFETs, so dass das interne Gate des insensitiven DEPFETs von Signalelektronen abgeschirmt wird. Gleichzeitig verhindern die Potenzialbarrieren auch den Verlust bereits gesammelter Ladung aus dem internen Gate des insensitiven DEPFETs.

In einer Variante der Erfindung haben die DEPFETs der Subpixel innerhalb eines Pixels eine gemeinsame Source, wobei die Drains der DEPFETs dann die Schirmelektroden bilden können.

In einer anderen Variante der Erfindung haben die DEPFETs der Subpixel dagegen innerhalb eines Pixels eine gemeinsame Drain, wobei die Sources der DEPFETs dann die Schirmelektroden bilden können.

Eine weitere Erfindungsvariante sieht dagegen separate Schirmelektroden vor, die von den Drains und Sources der DEPFETs getrennt und separat ansteuerbar sind.

Weiterhin besteht im Rahmen der Erfindung die Möglichkeit, dass die Schirmelektroden von mehreren Pixeln elektrisch miteinander verbunden sind.

Es wurde bereits vorstehend erwähnt, dass die strahlungsgenerierten Signalladungsträger mit einer hohen Selektivität nur in das interne Gate des DEPFETs des sensitiv geschalteten Subpixels gelangen, wohingegen das interne Gate des DEPFETs in dem insensitiv geschalteten Subpixel durch Potenzialbarrieren vor den strahlungsgenerierten Signalladungsträger abgeschirmt wird. Die Potenzialbarrieren zur Abschirmung des internen Gates des DEPFETs in dem insensitiv geschalteten Subpixel werden zum einen durch Schirmelektroden erzeugt, wie bereits vorstehend kurz erwähnt wurde. In einem Beispiel, das nützlich zum Verständnis der Erfindung ist, können diese Potenzialbarrieren aber auch dadurch erzeugt werden, dass die externen Gates der DEPFETs in dem sensitiv geschalteten Subpixel einerseits und in dem insensitiv geschalteten Subpixel andererseits unterschiedlich angesteuert werden.

Die bereits vorstehend erwähnte Selektivität bei der Ladungssammlung ist definiert als das Verhältnis zwischen der gesammelten Ladung des sensitiven Subpixels zu der Ladung, die das insensitive Subpixel eines Pixels sammelt. Eine Selektivität von 1000 bedeutet also, dass bei 1001 strahlungsgenerierten Signalladungsträgern 1000 der strahlungsgenerierten Signalladungsträger von dem sensitiv geschalteten Subpixel gesammelt werden, während nur ein einziger strahlungsgenerierter Signalladungsträger in dem insensitiv geschalteten Subpixel gesammelt wird. Die Erfindung ermöglicht vorteilhaft eine hohe Selektivität von mehr als 1000.

Simulationen haben gezeigt, dass eine hohe Selektivität bei der Ladungssammlung erzielt werden kann, wenn der Flächenanteil der Schirmelektroden an der Gesamtpixelfläche relativ hoch ist. Der Flächenanteil der Schirmelektroden an der Gesamtpixelfläche beträgt deshalb mindestens 10%, vorzugsweise mindestens 20% oder sogar mindestens 30%.

Weiterhin haben die Simulationen gezeigt, dass eine hohe Selektivität bei der Ladungssammlung erzielt werden kann, wenn der Abstand zwischen den internen Gates (bei einer gemeinsamen Source also die laterale Ausdehnung des gemeinsamen Source-Gebietes) als auch die Gate-Längen der DEPFETs kurz sind. Bei der erfindungsgemäßen Detektoranordnung ist der laterale Abstand zwischen den internen Gates der DEPFETs in den Subpixels eines Pixels deshalb wesentlich kleiner als die laterale Ausdehnung der Schirmelektroden.

Des Weiteren bewirkt eine höhere Potenzialdifferenz zwischen den beiden Schirmelektroden natürlich auch eine höhere Selektivität.

Eine vorteilhafte Ausgestaltung der Erfindung besteht darin, dass das Signal des insensitiv geschalteten DEPFETs ausgelesen werden kann, ohne dass das Auslesen durch in diesem Zeitraum eintreffende Ladung verfälscht wird und ohne dass die Ladungssammlung des sensitiv geschalteten Pixels wesentlich beeinträchtigt wird.

Es wurde bereits vorstehend kurz erwähnt, dass die Erfindung hinsichtlich der Anzahl der Subpixel pro Pixel nicht beschränkt ist auf zwei Subpixel pro Pixel. Beispielsweise umfasst die Erfindung auch eine Variante mit vier Subpixeln pro Pixel, wobei die Subpixel sequentiell sensitiv geschaltet werden und ansonsten insensitiv sind. Hierbei weist jedes Subpixel als Ausleseelement einen DEPFET auf. Die Subpixel können hierbei auf einem gemeinsamen Substrat angeordnet sein und durch einen Separator (z.B. aus Polysilizium) voneinander getrennt werden.

Darüber hinaus umfasst die erfindungsgemäße Detektoranordnung vorzugsweise auch eine Steuereinheit, welche den Halbleiterdetektor in geeigneter Weise ansteuert, um die Subpixel sensitiv bzw. insensitiv zu schalten und um zwischen dem Auslesebetrieb und dem Nicht-Auslesebetrieb umzuschalten. Zum einen ist die Steuereinheit hierzu mit den Schirmelektroden verbunden, um die Potentialbarrieren für die Abschirmung des insensitiven Subpixels zu erzeugen. Zum anderen ist die Steuereinheit aber auch mit Source bzw. Drain und externem Gate der DEPFETs der einzelnen Subpixel verbunden.

Zu dem Umschalten zwischen den verschiedenen Sammelzuständen ist zu bemerken, dass alle DEPFETs der Detektoranordnung, die sich im ersten Sammelzustand befinden, gleichzeitig in den zweiten Sammelzustand umgeschaltet werden können. Darüber hinaus können alle DEPFETs der Detektoranordnung, die sich im zweiten Sammelzustand befinden, gleichzeitig in den ersten Sammelzustand umgeschaltet werden.

Weiterhin können die einzelnen Pixel jeweils eine Driftstruktur aufweisen, welche die strahlungsgenerierten Signalladungsträger zu den DEPFETs driften lässt.

Ferner ist zu erwähnen, dass in jedem Pixel vorzugsweise immer ein Subpixel mit einem DEPFET als Ausleseelement sensitiv ist, so dass die einzelnen Pixel allenfalls beim Löschen der angesammelten Signalladungsträger eine Totzeit aufweisen und ansonsten totzeitfrei sind.

Gemäß der Erfindung sind die Pixel in der Detektoranordnung matrixförmig in Zeilen und Spalten angeordnet. Die Umschaltung zwischen den verschiedenen Sammelzuständen kann hierbei global erfolgen, wobei alle Pixel der Matrix gemeinsam zwischen den Sammelzuständen umgeschaltet werden, oder zeilenweise erfolgen, wobei sämtliche Pixel einer Zeile gemeinsam zwischen den Sammelzuständen umgeschaltet werden. Alternativ besteht die Möglichkeit, dass die Umschaltung zwischen den verschiedenen Sammelzuständen spaltenweise erfolgt, wobei sämtliche Pixel einer Spalte gemeinsam zwischen den Sammelzuständen umgeschaltet werden. Darüber hinaus kann auch die Umschaltung zwischen dem Auslesebetrieb und dem Nicht-Auslesebetrieb zeilenweise oder spaltenweise erfolgen. In einem Beispiel, das nützlich für das Verständnis der Erfindung ist, wird auch ein entsprechendes Betriebsverfahren für einen Halbleiterdetektor mit mehreren Pixeln und jeweils mindestens zwei Subpixeln pro Pixel offenbart. Im Rahmen des Betriebsverfahrens werden die Subpixel nacheinander sensitiv bzw. insensitiv geschaltet, wobei jeweils in dem sensitiven Subpixel strahlungsgenerierte Signalladungsträger gesammelt werden, während das insensitiv geschaltete Subpixel abgeschirmt ist und keine strahlungsgenerierten Signalladungsträger sammelt.

Das Auslesen der in den Subpixeln angesammelten Signalladungsträger erfolgt dann jeweils in einem Auslesebetrieb.

In einer Variante werden die Subpixel jeweils im insensitiven Zustand ausgelesen. Das erste Subpixel wird dann also im zweiten Sammelzustand ausgelesen, in dem das erste Subpixel insensitiv ist, während das zweite Subpixel sensitiv ist. Das zweite Subpixel wird hierbei im ersten Sammelzustand ausgelesen, in dem das erste Subpixel sensitiv ist, während das zweite Subpixel insensitiv ist.

In einer anderen Variante werden die Subpixel dagegen jeweils im sensitiven Zustand ausgelesen. Das erste Subpixel wird dann also im ersten Sammelzustand ausgelesen, in dem das erste Subpixel sensitiv ist, während das zweite Subpixel insensitiv ist. Das zweite Subpixel wird hierbei im zweiten Sammelzustand ausgelesen, in dem das erste Subpixel insensitiv ist, während das zweite Subpixel sensitiv ist.

Bei der vorstehend beschriebenen Variante eines Halbleiterdetektors mit vier Subpixeln pro Pixel werden die Subpixel vorzugsweise nacheinander sensitiv bzw. insensitiv geschaltet. Vorzugsweise ist hierbei jeweils nur ein Subpixel pro Pixel sensitiv, während die anderen Subpixel des Pixels insensitiv sind.

Ferner ist zu erwähnen, dass der sensitive Zustand der einzelnen Subpixel vorzugsweise nur sehr kurz eingestellt wird, beispielsweise für eine Dauer von weniger als 1ms, 100µs oder sogar weniger als 10µs.

Andere vorteilhafte Weiterbildungen der Erfindung sind in den Unteransprüchen gekennzeichnet oder werden nachfolgend unter Bezugnahme auf die Zeichnungen näher erläutert.

### Kurze Beschreibung der Zeichnungen

Figur 1A zeigt ein Ersatzschaltbild eines Pixels einer erfindungsgemäßen Detektoranordnung, wobei das Pixel zwei Subpixel aufweist.
Figur 1B zeigt eine Querschnittsansicht durch das Pixel gemäß Figur 1A entlang der Schnittlinie A-A in Figur 1D.
Figur 1C zeigt den Verlauf von elektrischen Feldlinien und Äquipotentiallinien in dem Pixel der Detektoranordnung gemäß den Figuren 1A und 1B.
Figur 1D zeigt eine Aufsicht auf das Pixel gemäß den Figuren 1A-1C.
Figur 2A zeigt eine Abwandlung von Figur 1A.
Figur 2B zeigt eine entsprechende Abwandlung von Figur 1B.
Figur 3 zeigt eine Aufsicht auf eine erfindungsgemäße Detektoranordnung mit zwei Pixeln mit jeweils zwei Subpixeln mit einer Driftstruktur.
Figur 4 zeigt eine Abwandlung von Figur 1D mit zusätzlichen Schirmelektroden getrennt von den DPEFETs.
Figur 5 zeigt eine Abwandlung eines Pixels mit vier Subpixeln.
Figur 6 zeigt die Verschaltung von mehreren Pixeln mit jeweils zwei Subpixeln in einer Sensormatrix.
Figuren 7A, 7B zeigen die Abfolge der verschiedenen Sammelzustände bei der Sensormatrix gemäß Figur 6.
Figur 8 zeigt die Verschaltung von mehreren Pixeln mit jeweils vier Subpixeln in einer Sensormatrix.
Figuren 9A-9D zeigen die Abfolge der verschiedenen Sammelzustände bei der Sensormatrix gemäß Figur 8.

### Detaillierte Beschreibung der Zeichnungen

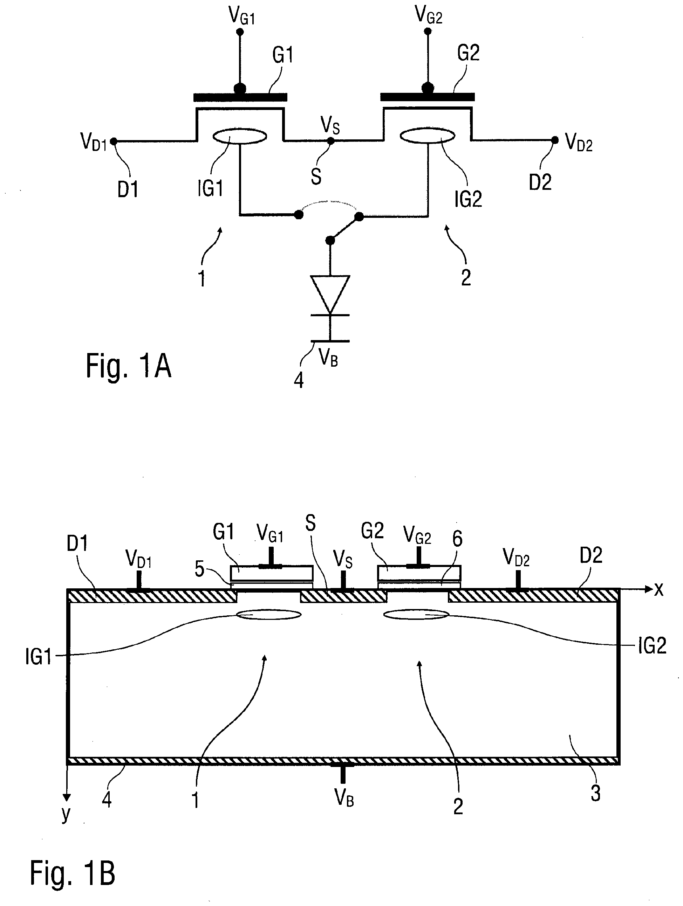

Im einfachsten Fall gemäß den Figuren 1A-1D besteht ein Pixel der erfindungsgemäßen Detektorstruktur aus zwei benachbarten DEPFETs 1, 2 mit jeweils einer gemeinsamen Source S, jeweils einem Drain D1, D2, jeweils einem internen Gate IG1, IG2 und jeweils einem externen Gate G1, G2, wobei sich die DEPFETs 1, 2 an der Oberfläche eines schwach n-dotierten (hochohmigen) Siliziumwafers 3 befinden und jeweils ein Subpixel bilden.

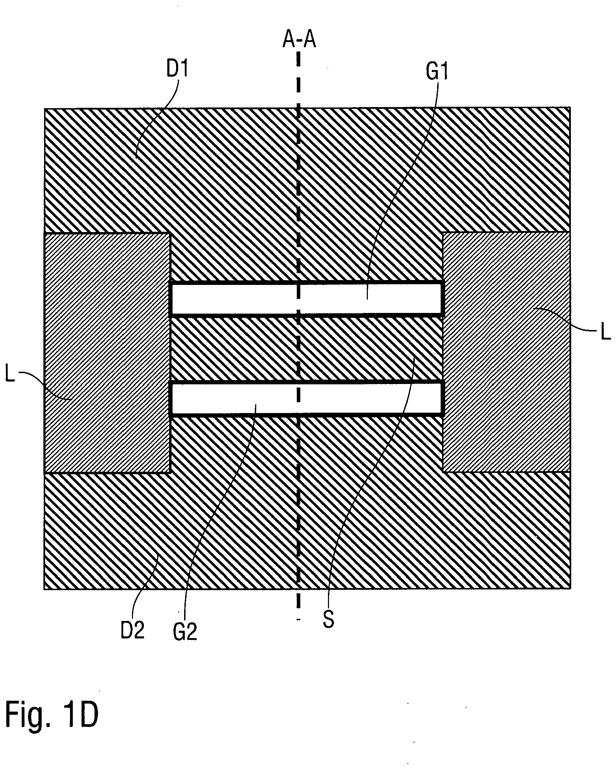

Die Figuren 1B und 1D zeigen einen Querschnitt und das dazugehörige Layout (Draufsicht).

Der Siliziumwafer 1 weist im Bereich einer aus den DEPFETs 1, 2 bestehenden Sensormatrix an der Rückseite eine stark p-dotierte dünne Schicht 4 auf. An der Oberseite des Siliziumwafers 1 sind die eigentlichen DEPFETs 1, 2 angeordnet. Sie werden durch die externen (MOS-) Gates G1, G2 mit Dielektrika 5, 6 gebildet. Das den beiden DEPFETs 1, 2 gemeinsame Source-Gebiet S und die Drains D1, D2 begrenzen die Transistorkanäle, unter welchen sich die internen Gates IG1 und IG2 befinden. Diese dienen beim Sammeln der im Bulk generierten Signalladung als Sammelelektroden und beim Auslesen als zusätzliche, die Kanäle steuernde Elektroden.

Die beiden DEPFETs 1, 2 bilden zusammen mit einer Löschstruktur L (vgl. Figur 1D) ein Pixel mit zwei Subpixeln. Die in diesem Bereich einfallende Ladung wird diesem Pixel zugeordnet. Die beiden DEPFETs 1, 2, in deren internen Gates IG1, IG2 abwechselnd die Ladungsspeicherung erfolgt, werden im Rahmen der Erfindung als Subpixel bezeichnet. Ein Sensor besteht üblicherweise aus einer matrixförmigen Anordnung von Pixeln.

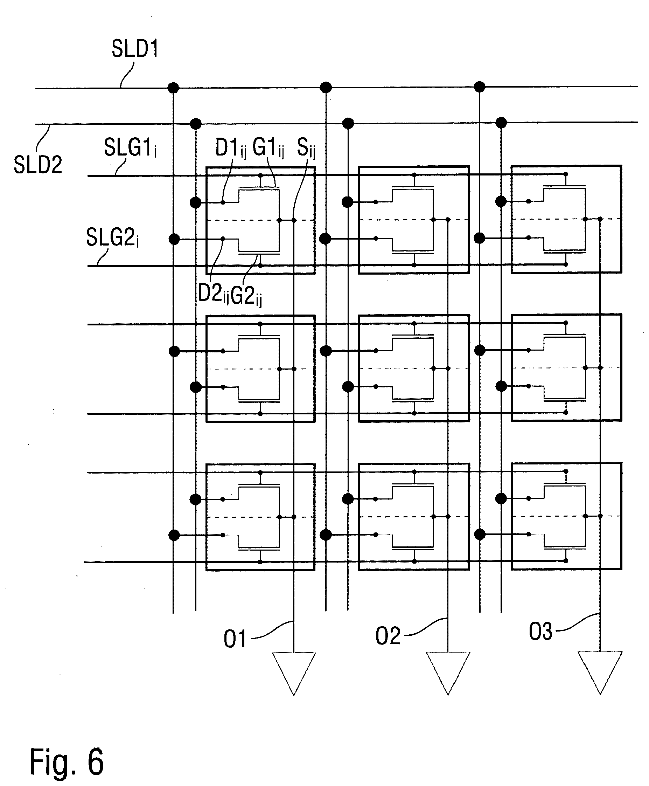

Im Folgenden wird der Betrieb des Pixels beschrieben. Bei diesem Ausführungsbeispiel liegt der Fokus auf der Totzeitminimierung beim Auslesen von DEPFET-Matrizen, zudem wird die Funktion der Schirmelektroden durch die Drains D1, D2 der DEPFETs 1, 2 übernommen. Eine Verschaltung der Pixel innerhalb einer Matrix gemäß dem unten beschriebenen Ausführungsbeispiel ist in Figur 6 gezeigt.

Hierbei dienen Steuerleitungen SLD1 und SLD2 zur Ansteuerung der Drains D1ᵢⱼ bzw. D2ᵢⱼ der einzelnen Subpixel. Jede Drain D1ᵢⱼ bzw. D2ᵢⱼ der einzelnen Subpixel ist hierbei mit einer der beiden Steuerleitungen SLD1 und SLD2 verbunden und zwar in den einzelnen Spalten jeweils abwechselnd.

Weiterhin weist jede Zeile der Matrix zwei Steuerleitungen SLG1ᵢ und SLG2ᵢ auf, die mit den Gates G1ᵢⱼ bzw. G2ᵢⱼ von allen Pixeln der jeweiligen Zeile verbunden sind.

Schließlich sind die gemeinsamen Sources Sij der Pixel innerhalb einer Spalte mit jeweils einer Ausgangsleitung O1, O2 bzw. O3 pro Spalte verbunden.

### Ladungssammlung und Ladungsspeicherung

Während aller Betriebsphasen ist der Siliziumwafer 1 depletiert. Die Depletion (Ladungsträgerverarmung) ergibt sich durch eine relativ hohe, an der rückseitigen Schicht 4 angelegte negative Spannung V_{B} im Zusammenspiel mit der Depletionswirkung der p⁺-dotierten Drains D1, D2 und der ebenfalls p⁺-dotierten Source S und dem Löschvorgang.

Beim Sammeln der Signalladung sind beide Subpixel ausgeschaltet, d.h. die externen Gates G1, G2 befinden sich auf relativ positivem Potenzial V_{G1} bzw. V_{G1} gegenüber einem Referenzpotenzial V_{S} der Source S. Der Einfachheit halber sollen die Schwellenspannungen der DEPFETs 1, 2 bei leeren internen Gates IG1, IG2 bei 0V liegen, so dass die DEPFETs 1, 2 sperren. Kennzeichnend für die Erfindung ist, dass die Drains D1, D2 der beiden Subpixel, die zugleich als Schirmelektroden dienen, auf unterschiedlichen Potenzialen liegen. Das eine Drain D1 liegt, wie bei p-Kanal-Transistoren üblich, auf einem negativen Potenzial (V_{D1}=-5V). Das andere Drain D2 wird auf ein relativ dazu positives Potenzial geschaltet (V_{D2}=0V).

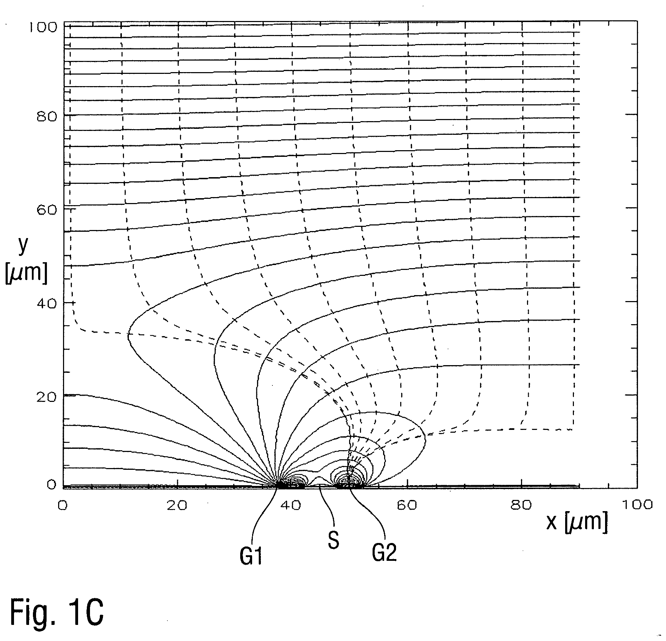

Figur 1C zeigt den sich dann ergebenen simulierten zweidimensionalen Potenzialverlauf innerhalb eines nach den Figuren 1B und 1D gestalteten Pixels im Schnitt A-A. Da sich die Simulationen auf ein rechtshändiges Koordinatensystem beziehen, befindet sich die Oberfläche des Siliziumwafers 3 mit den DEPFETs 1, 2 bei der Koordinate y=0 und die Rückseite mit der p⁺-dotierten Schicht 4 bei y=450µm. Dargestellt ist die Potenzialverteilung innerhalb der ersten 100µm. Die durchgehenden Linien sind Linien gleichen Potenzials (Iso-Potenziallinien). Senkrecht dazu verlaufen die gestrichelt gezeichneten elektrischen Feldlinien. Sie bilden die Trajektorien für die Signalelektroden und wurden so gewählt, dass sie den Halbleiter unterhalb des Pixels überstreichen. Sie enden alle in dem internen Gate IG2 des rechten Subpixels, dessen Drain D2 auf 0V liegt, auch wenn die Trajektorien unter dem linken Subpixel starten. Das interne Gate IG1 des linken Subpixels sammelt keine Ladung.

Wie schon erwähnt, fungieren in diesem Ausführungsbeispiel die Drains D1, D2 als Schirmelektroden. Sie weisen die Ladung vom linken Subpixel ab und leiten sie zum rechten Subpixel. Wesentlicher Bestandteil der Erfindung ist, dass die Rollen der beiden Subpixel getauscht werden. Dazu müssen nur die an den Schirmelektroden anliegenden Spannungswerte umgeschaltet werden. Subpixel, deren Schirmelektrode auf positivem Potenzial liegen und die somit Elektronen sammeln können, werden im Folgenden als sensitiv bezeichnet. Dagegen sind Subpixel mit auf negativem Potenzial liegenden Schirmelektroden, also abgeschirmten internen Gates, insensitiv. Der Vorteil dieses Sensorbauelementes wird bei der Betrachtung des Auslesevorgangs deutlich.

### Auslesen

Wie im Stand der Technik beschrieben, werden DEPFET-Matrizen bevorzugt zeilenweise, im Rolling-Shutter-Modus, ausgelesen. Das in der gesamten Matrix gespeicherte Bild wird Frame genannt. Bei einer Matrix mit n Zeilen werden demzufolge n Auslesevorgänge benötigt, um einen Frame zu erhalten. Zum Auslesen einer Zeile wird das entsprechende Gate aktiviert, so dass die DEPFETs dieser Zeile leitfähig werden.

Bei einer Stromauslese wird der Signalstrom, d.h. der von der Ladung im internen Gate IG1 bzw. IG2 modulierte Transistorstrom, von einer am Rand der Matrix angeordneten Ausleseelektronik erfasst und zwischengespeichert.

Bei der alternativen Spannungsauslese (Source-Folger) lädt der aktivierte DEPFET 1 bzw. 2 die Ausleseleitung um, die den Transistor mit der Ausleseelektronik verbindet. Dort wird dann der Signalspannungswert erfasst und zwischengespeichert. Anschließend erfolgt die Referenzwertbestimmung. Dazu wird die Ladung aus dem internen Gate IG1 bzw. IG2 mit Hilfe der Löschstrukturen L (vgl. Figur 1D) entfernt (gelöscht). Der danach gemessene Strom- bzw. Spannungswert repräsentiert den Ladungszustand des leeren internen Gates IG1 bzw. IG2. Als Maß für die zuvor gesammelte Ladung wird in der Ausleseelektronik die Differenz von Signal- und Referenzwert, also der Werte vor und nach dem Löschen, gebildet. Diese bekannte Technik wird "Correlated Double Sampling" (CDS) genannt.

Wie bereits dargelegt wurde, werden Signale, die während des Auslesens das interne Gate IG1 bzw. IG2 erreichen, nicht richtig erfasst, weil entweder der Signal- oder der Referenzwert durch die eintreffenden Ladungsträger verfälscht wird, was bei der Differenzbildung fehlerhafte Werte ergibt.

In dem erfindungsgemäßen Pixel gibt es (in diesem Ausführungsbeispiel) ein sensitives und ein insensitives Subpixel. Beim insensitiven (linken) Subpixel liegt am Drain D1 eine negative Spannung an, wodurch das interne Gate IG1 abgeschirmt wird. Gleichzeitig kann das Subpixel aber durch das Aktivieren des zugehörigen Gates G1 ausgelesen werden. Auf diese Weise wird sichergestellt, dass während des Auslesevorganges keine Ladung das interne Gate IG1 erreichen kann, die sogenannten "Misfit" Ereignisse also effizient unterdrückt werden. Anders als bei einer Lösung, die alleine auf einem elektronischen Verschluss basiert, geht die während der Auslesezeit eintreffende Signalladung nicht verloren, sondern wird in das interne Gate IG2 des anderen, gerade sensitiven Subpixels geleitet.

In diesem Ausführungsbeispiel erfolgt das Umschalten der Spannungen an den Schirmelektroden, in diesem Fall der Drains D1, D2, global. Überall auf der Matrix werden gleichzeitig aus insensitiven Subpixeln sensitive Subpixel und umgekehrt. Das Auslesen der Matrix (Frame-Auslese) kann dann, wie gehabt, zeilenweise erfolgen. Hierbei wird in jedem Pixel einer aktivierten Matrixzeile nur das insensitive Subpixel ausgelesen, während das sensitive Subpixel weiterhin Signale sammeln kann. Im Bedarfsfall schließt sich an den Auslesevorgang eine zusätzliche Integrationszeit an, während der nur Signal gesammelt, aber nicht ausgelesen wird. In diesem Zustand sind alle externen Gates G1 bzw. G2 abgeschaltet.

Ist das Auslesen abgeschlossen, werden vor dem Beginn des nächsten Auslesezyklus die Rollen der Subpixel wieder durch globales Umschalten der Schirmelektroden (d.h. der Drains D1, D2) getauscht. In den vormals sensitiven Subpixeln ist jetzt sowohl die während der letzten Integrationszeit gesammelte Ladung gespeichert als auch die Signalladung, die während des vorangegangenen Auslesezyklus eingetroffen war. Auch die letztere Bildinformation wird im jetzt anstehenden Auslesezyklus unverfälscht erfasst.

Bei einem auf der erfindungsgemäßen Detektorstruktur basierenden und wie beschrieben betriebenen Sensor können so keine Misfits auftreten und ihre Unterdrückung ist nicht mit zusätzlicher Totzeit verbunden. Echte Vorteile bieten sich daher besonders bei der wiederholten Erfassung von ROIs mit hoher Bildrate und bei der Auslese von Sensoren mit hohem Parallelisierungsgrad.

Erstere ist mit klassischen DEPFETs zwar durchführbar, aber aufgrund des ungünstigen Verhältnisses von Integrations- zu Auslesezeit ist die spektroskopische Qualität deutlich schlechter als für die Vollbild-Auslese.

Gleiches gilt für die Auslese von Sensoren mit hohem Parallelisierungsgrad. Bei einem "klassischen" DEPFET ist der Anteil an Misfits hierbei direkt proportional zur Anzahl der gleichzeitig ausgelesenen Pixel. Der ungünstigste Fall entspricht also der vollparallelen Auslese, d.h. einem hybriden Pixelsensor, bei dem alle Pixel gleichzeitig ausgelesen werden. Ein auf der erfindungsgemäßen Detektorstruktur basierender Sensor hingegen liefert auch bei maximalem Parallelisierungsgrad verwertbare Daten von gleichbleibend guter spektroskopischer Qualität.

Darüber hinaus bietet die beschriebene Ausführung eines solchen Sensors einen weiteren Vorteil. Aufgrund des gleichzeitigen, globalen Umschaltens ist die Bilderfassung instantan, wodurch keine Artefakte durch "Rolling Shutter"-Effekte auftreten können. Diese wirken sich insbesondere bei der Bildgebung schnell veränderlicher Objekte im Optischen störend aus.

Das Umschalten der Schirmelektroden (d.h. der Drains D1, D2) kann sehr schnell erfolgen. Zwar müssen alle zu den Schirmelektroden führenden Steuerleitungen gleichzeitig umgeladen werden, was zu einer hohen kapazitiven Last führt, dafür können jedoch spezielle Treiber-Chips verwendet werden, von denen nur zwei pro Matrix gebraucht werden. Diese Situation ist durchaus vergleichbar mit dem globalen Schalten von Registern in einem CCD, wofür üblicherweise deutlich weniger als 100ns erforderlich sind. Jedoch muss das Umschalten der Subpixel bloß einmal vor jedem Auslesezyklus erfolgen, während bei einem 3-Phasen-CCD drei Takte pro Zeilenauslese erforderlich sind. Damit fällt die Verlustleistungsbilanz für die DEPFET-Matrix wesentlich günstiger aus. Es kann natürlich passieren, dass Signalladung, die das Pixel während des kurzen Umschaltvorgangs erreicht, auf beide Subpixel aufgeteilt wird. Diese Ladung ist jedoch nicht verloren. Sie kann bei Bedarf bei einer nachträglichen Analyse der Daten korrekt rekonstruiert werden.

Beide Subpixel werden über gemeinsame Löschstrukturen L zurückgesetzt, die links und rechts an die internen Gates IG1, IG2 anschließen (vgl. Figur 1D). Dies ist ein sehr platzsparendes Layout, vor allem weil sich die Anzahl der Ansteuerleitungen als auch die der Treiber-Chips für den Löschvorgang halbieren. Allerdings wird dazu vorausgesetzt, dass die insensitiven Subpixel während des Löschvorgangs ihre Ladung behalten können, was durch ein hinreichend positives Potenzial der internen Gates dieser Subpixel gewährleistet wird. Aus technologischen Gründen kann es jedoch vorkommen, dass dieses positive Potenzial nicht einstellbar ist, z.B. weil die damit verbundenen elektrischen Felder Ladungsträgermultiplikationen im Bereich des internen Gates auslösen. Dann sollte die aufwändigere Anordnung, bei der jedes Subpixel über eine eigenständig ansteuerbare Löschstruktur verfügt, gewählt werden.

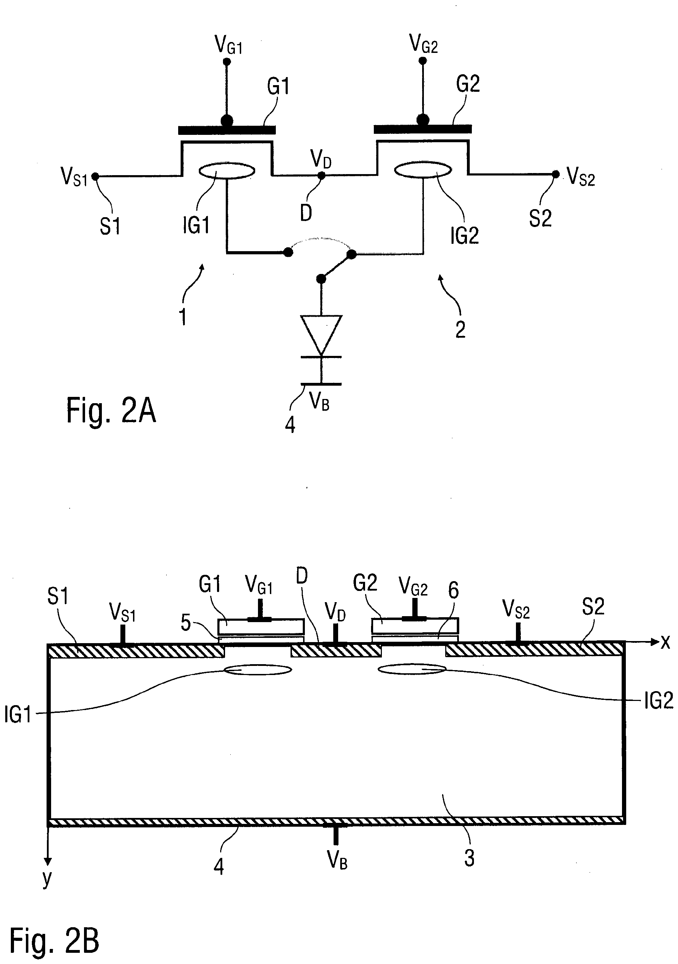

Die Figuren 2A und 2B zeigen eine Abwandlung des Ausführungsbeispiels gemäß den Figuren 1A-1D, so dass zur Vermeidung von Wiederholungen auf die vorstehende Beschreibung verwiesen wird, wobei für entsprechende Einzelheit dieselben Bezugszeichen verwendet werden.

Eine Besonderheit dieses Ausführungsbeispiels besteht darin, dass die beiden DEPFETs 1, 2 eine gemeinsame Drain D und getrennte Sources Sl, S2 haben.

So besteht eine weitere Möglichkeit, die Selektivität der Ladungssammlung zwischen dem sensitiven und den insensitiven Subpixeln zu verbessern, darin, die Rollen von Drain und Source zu vertauschen. Dazu wird die zwei Subpixeln gemeinsame p⁺-dotierte Region nicht, wie in den bisher vorgestellten Ausführungsbeispielen, auf Source-Spannung, sondern auf die negative Drain-Spannung gelegt. Beim Lesen wird hier wiederum das Signal abgegriffen. Die außen liegenden Sources Sl, S2 fungieren zwar weiterhin als Schirmelektroden und werden wieder zwischen einer positiven (sensitives Subpixel) und einer negativen Spannung (insensitives Subpixel) geschaltet. Die Schirmelektrode des insensitiven Subpixels kann hierbei deutlich negativer als die gemeinsame Drain D geschaltet werden. Da somit die Potentialdifferenz zwischen den Schirmelektroden (d.h. den Sources S1, S2) größer als die Source-Drain-Spannung der DEPFETs 1, 2 werden kann, lassen sich deutlich höhere Werte für die Selektivität erreichen.

Zum Auslesen muss die Schirmelektrode Sl, S2 allerdings die Funktion der Source übernehmen, und hierzu muss sie auf eine relativ zum Drain D positiven Spannung, z.B. 0V, gelegt werden. Dies entspricht jedoch dem sensitiven Zustand, d.h. das Pixel kann nur im sensitiven Zustand ausgelesen werden.

Dadurch geht der Vorteil der Misfit-Unterdrückung verloren. Der Vorteil der Struktur besteht in der deutlich erhöhten Selektivität der Ladungssammlung. Weiterhin lässt sich für diese Struktur eine strombasierte Auslese des Signals an der Drain D, die Vorteile im Hinblick auf die erreichbare Auslesegeschwindigkeit bietet, mit deutlich geringerem Aufwand realisieren.

Die Verwendung einer solchen Detektorstruktur ist also vor allem dann vorteilhaft, wenn das Auslesen des Sensors nach der Beendigung der Integrationsphase erfolgen kann, oder wenn eine hohe Selektivität benötigt wird, der Einfluss von Misfits im Spektrum aber vernachlässigbar ist.

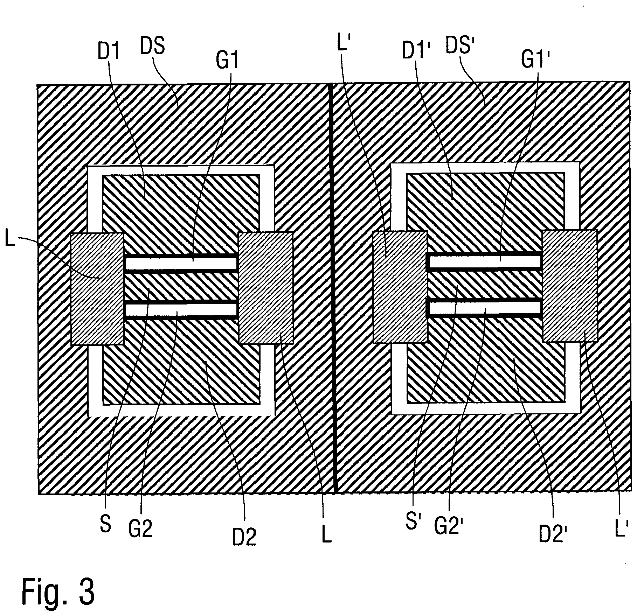

Das Ausführungsbeispiel gemäß Figur 3 stimmt ebenfalls teilweise mit den vorstehend beschriebenen Ausführungsbeispielen überein, so dass zur Vermeidung von Wiederholungen auf die vorstehende Beschreibung verwiesen wird, wobei für entsprechende Einzelheit dieselben Bezugszeichen verwendet werden.

So zeigt Figur 3 die beispielhafte Einbettung von zwei der oben beschriebenen Pixel mit jeweils zwei Subpixeln in eine Driftstruktur DS. Selbstverständlich sind auch andere Formen von Driftstrukturen und auch mehrere konzentrisch angeordnete ringförmige Driftstrukturen einsetzbar.

Sehr sinnvoll kann die Realisierung von Driftstrukturen DS auch durch abgestufte Implantationen sein, wenn dabei Implantationsschritte zur Anwendung kommen, die ohnehin im technologischen Herstellungsprozess eingesetzt werden. Die mit den Implantationen verbundenen Raumladungen können die Signalladung in Richtung der internen Gates IG1 bzw. IG2 fokussieren bzw. können auch zur Abgrenzung der Pixel verwendet werden.

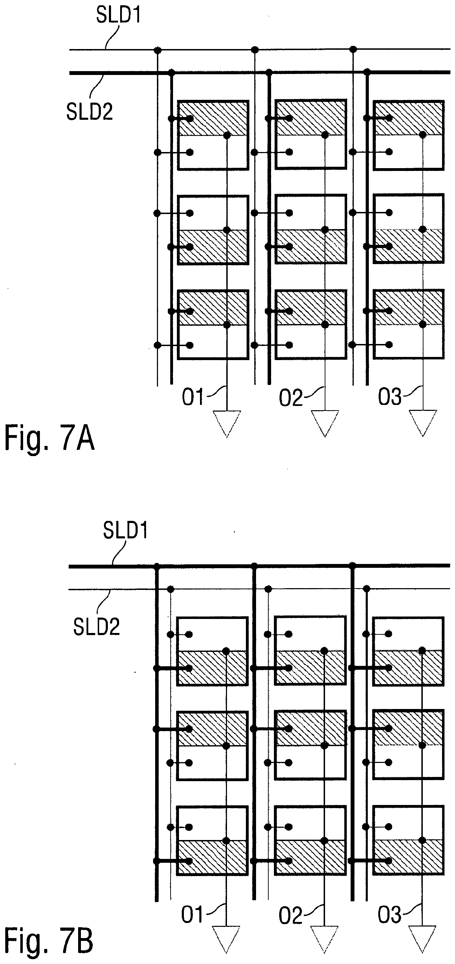

Auch Platzierung und Verschaltung der Pixel innerhalb der Matrix haben Einfluss auf die Selektivität. Bei der in den Figuren 1A-1D gezeigten Auslegung führt eine spiegelsymmetrische Verschaltung in Bezug auf die linke und rechte (Figur 1B) bzw. die obere und untere Pixelgrenze (Figur 1D) dazu, dass sich in Ausleserichtung benachbarte Pixel die als Schirmelektroden fungierenden Drain-Gebiete D1, D2 teilen. Damit ergibt sich eine hohe Selektivität, weil sich die Flächen der Schirmelektroden de facto verdoppeln. Beim Auslesen muss berücksichtigt werden, dass die Pixel alternierend jeweils mit ihren sensitiven bzw. insensitiven Subpixeln aneinander grenzen. Die Abfolge der Ansteuerung der verschiedenen Subpixel und ihre Zusammengehörigkeit innerhalb der Matrix sind in den Figuren 7A und 7B dargestellt.

Wie in der Figur 1D dargestellt, werden die Schirmelektroden zu den seitlichen Nachbarn hin nicht unterbrochen, was zu einer zusätzlichen Flächenvergrößerung führt. Das Signal wird an der Source S ausgelesen.

Die Verschaltung der Pixel innerhalb einer Sensormatrix wird in Figur 6 gezeigt.

Eine weitere sehr effektive Möglichkeit die Selektivität zu steigern, besteht darin, während des Sammelns das Potenzial des internen Gates IG1 des insensitiven Subpixels gegen über dem des sensitiven internen Gates IG2 abzusenken. Das kann sehr leicht über das externe Gate G1 erfolgen. Im abgeschalteten Zustand existiert in dem DEPFET 1 kein Löcherkanal, so dass das externe Gate G1 kapazitiv auf das interne Gate IG1 durchgreifen kann. Diese kapazitive Kopplung ermöglicht es, das Potenzial des internen Gates IG1 über die Spannung am externen Gate G1 einzustellen. Beispielhaft können folgende Spannungen an den externen Gates G1, G2 eingestellt werden:
- Insensitives Pixel im Lesezustand: -3V,
- insensitives Pixel im Sammelzustand 1V,
- sensitives Pixel im Sammelzustand 3V.
Im oben gezeigten Simulationsbeispiel (Figur 1C) verbessert sich die Selektivität gegenüber dem Standardbetrieb; Sammelzustand: externes Gate des insensitiven Subpixels = externes Gate des insensitiven Subpixels = 3V) um fast eine Größenordnung von 9.4e04 auf 8.5e05. Diese Verbesserung wird natürlich durch eine kompliziertere Ansteuerung erkauft. Eine technische Lösungsmöglichkeit besteht darin, für den Ansteuer-Chip für die Gate-Leitungen eine 3-Niveautaktung vorzusehen.
Die Auslesezeit eines Frames ist, beim Betrieb der Matrix im Rolling-Shutter-Modus, gleich der Summe der für die einzelnen Zeilen benötigten Auslesezeiten. Das limitiert die Zeitauflösung des Detektors, was selbst durch das parallele Auslesen mehrerer Zeilen oder durch die Einführung von ROIs nicht in allen Anwendungsfällen kompensierbar ist. In diesen Fällen führt die Verwendung erfindungsgemäßer Pixel durch die Unterdrückung der Misfits zwar zu einer deutlichen Verbesserung der spektroskopische Qualität der Signale, das Problem der geringen Zeitauflösung wird aber nicht behoben.

Beim hybriden DEPFET-Pixelsensor wird mit Hilfe von 3D-Integrationstechniken jedem DEPFET-Pixel ein eigener Ausleseverstärker zugeordnet. Diese Verstärker sind innerhalb eines Auslese-Chips ebenfalls matrixförmig angeordnet. Der Auslesevorgang kann also vollständig parallel mit maximal möglicher Zeitauflösung ablaufen. Wie bereits ausgeführt, ist das vom Standpunkt der 'Misfit-Unterdrückung' jedoch der ungünstigste Fall. Die Verwendung des erfindungsgemäßen Pixels als Sensorelement ist hier deshalb besonders vorteilhaft. Es bietet sich an, das beiden Subpixeln gemeinsame Source-Gebiet über einen Bumpbond mit dem Eingang des zugeordneten Verstärkers zu verbinden.

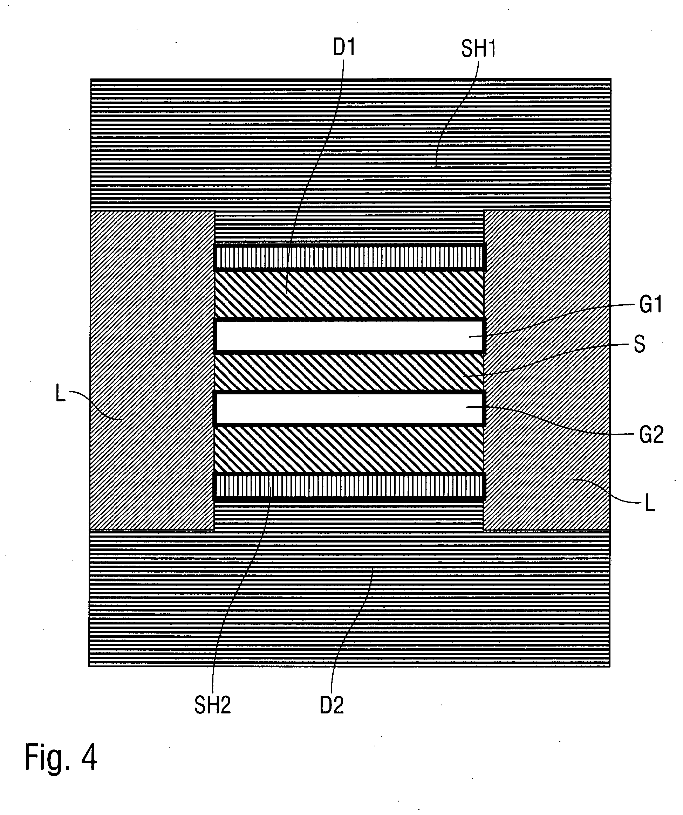

Das Ausführungsbeispiel gemäß Figur 4 stimmt ebenfalls teilweise mit den vorstehend beschriebenen Ausführungsbeispielen überein, so dass zur Vermeidung von Wiederholungen auf die vorstehende Beschreibung verwiesen wird, wobei für entsprechende Einzelheit dieselben Bezugszeichen verwendet werden.

So weist dieses Ausführungsbeispiel separate Schirmelektroden SH1, SH2 auf, die von den Drains D1, D2 getrennt sind. Die Schirmelektroden SH1, SH2 müssen also nicht zwangsläufig durch die Drains D1, D2 der DEPFETs 1, 2 gebildet werden. Wird in einem Detektor die schnellere Stromauslese benötigt, werden üblicherweise die Drains D1, D2 mit den Verstärkern der Ausleseelektronik-Chips verbunden. Wenn diese über einen größeren Spannungsbereich getaktet werden, müssen Vorkehrungen getroffen werden, um den Verstärkereingang zu entkoppeln. Dies kann vermieden werden, wenn man die Abschirmfunktion auf die weiter außen angeordneten separaten Schirmelektroden SH1, SH2 überträgt. Dazu bieten sich, wie in Figur 4 dargestellt, die Driftstrukturen an. Um einen wirksamen Potenzialdurchgriff auf die Regionen unterhalb der internen Gates IG1, IG2 zu gewährleisten, sollten die dazwischen liegenden Drain-Gebiete D1, D2 relativ schmal sein. Ein Vorteil dieser Anordnung ist, dass die Wahl der Spannungsdifferenzen an den Schirmelektroden SH1, SH2 unabhängig von der Transistorfunktion erfolgen kann. Sie können durchaus im Bereich von 10V oder 20V liegen, wodurch die größere Entfernung vom internen Gate IG1 bzw. IG2 kompensiert werden kann. Die positivere Schirmelektrodenspannung für die sensitiv geschalteten Subpixel sollte jedoch nicht positiver als die Drain-Spannung sein, weil sich ansonsten Potenzialbarrieren für die Signalelektronen aufbauen würden.

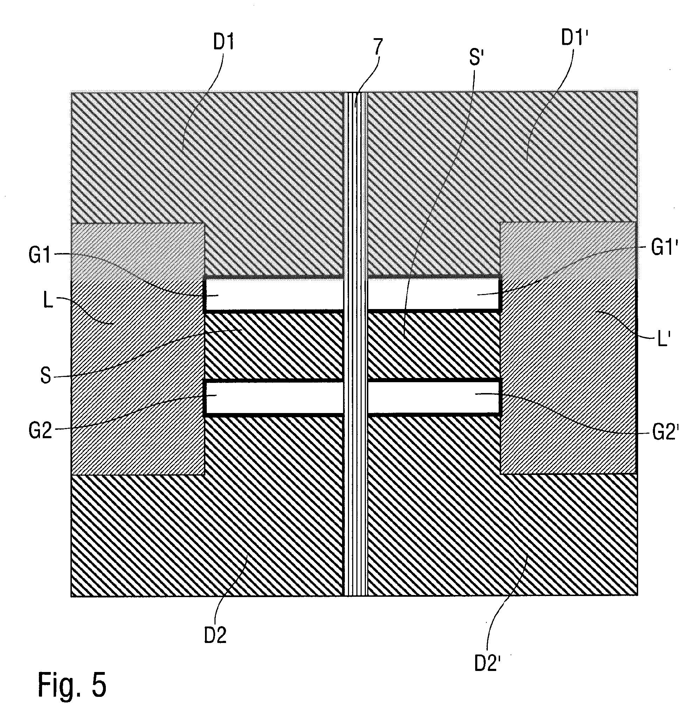

Das Ausführungsbeispiel gemäß Figur 5 stimmt ebenfalls teilweise mit den vorstehend beschriebenen Ausführungsbeispielen überein, so dass zur Vermeidung von Wiederholungen auf die vorstehende Beschreibung verwiesen wird, wobei für entsprechende Einzelheit dieselben Bezugszeichen verwendet werden.

Hierbei ist zu erwähnen, dass das Umschalten der Schirmelektroden auch häufiger erfolgen kann als das Auslesen der Bildinformation. Da es sehr schnell und ohne Verlust der Signalladung erfolgt, können Signalladungen damit m unterschiedlichen zeitlichen Phasen der Bilderfassung zugeordnet werden. Dabei sei m die Anzahl der Subpixel eines Pixels. Das Umschalten der Schirmelektroden erfolgt auch hier simultan für die ganze Matrix. Eine typische Anwendung für bildgebende Polarimetrie würde 4 Subpixel verwenden, wie in Figur 5 dargestellt.

Im Unterschied zu der in den Figuren 1A-1D gezeigten Anordnung, werden die beiden Subpixel durch einen vorzugsweise aus einer ersten Polysilizium-Schicht gebildeten Separator 7 getrennt. Die externen Gates G1, G2 der DEPFETs werden aus einer später abgeschiedenen zweiten Polysiliziumschicht geformt. Bei der Fertigung blockt die erste Polysiliziumschicht des Separators 7 die Implantationen, die die Kanäle und die internen Gates bilden ab, so dass diese getrennt werden und sich innerhalb eines Pixels interne Gates ausbilden. Der Separator 7 teilt auch die p⁺-implantierten Schirmelektroden (Drains) und das p⁺-implantierte Source-Gebiet, wodurch letztlich vier Subpixel mit jeweils einer Schirmelektrode entstehen.

Der Separator 7 wird auf eine leicht positive Spannung von ca. 1V gelegt, um parasitäre Kanäle zwischen den p⁺-dotierten Gebieten zu unterdrücken. Bei Verwendung einer zusätzlichen n-Implantation im vom Separator 7 überdeckten Silizium verschiebt sich diese Spannung zu negativeren Werten.

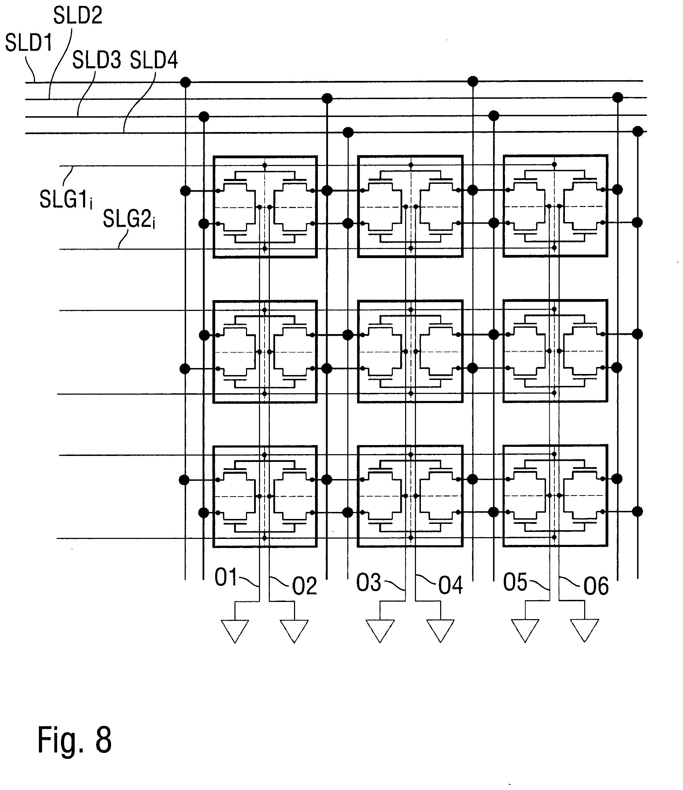

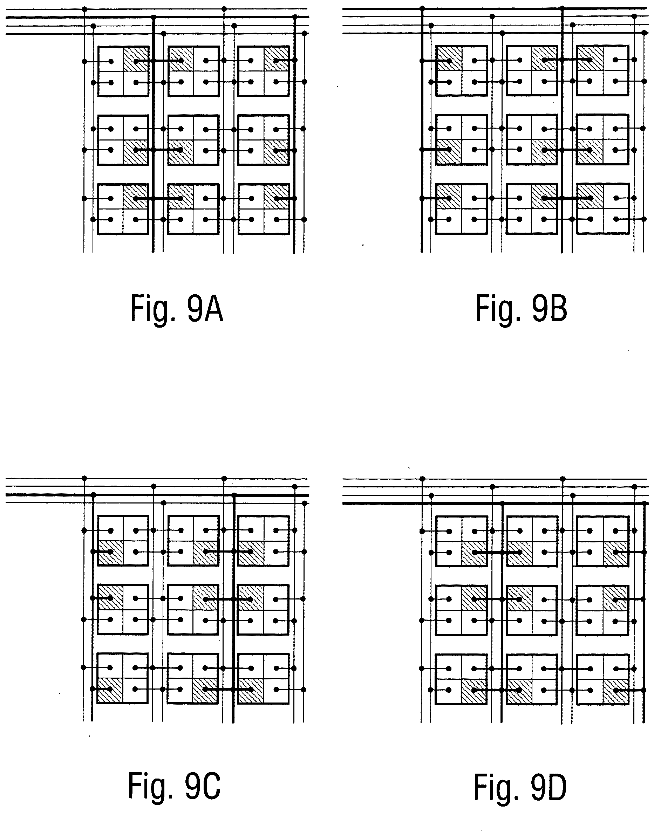

In einem Polarimeter wird dazu synchron zum Schalten des Modulators jeweils genau eine der vier Schirmelektroden in den Sammelmodus (0V) geschaltet, während alle anderen die Ladung abweisen (Schirmelektroden auf -5V). Wurde beispielsweise während der ersten Polarisatorstellung die Signalladung im ersten Subpixel gesammelt, wird simultan mit dem Umschalten des Polarisators über die zweite Schirmelektrode das zweite Subpixel sensitiv geschaltet und das erste über seine Schirmelektrode insensitiv. Ebenso wird für die dritte und vierte Polarisatorstellung verfahren. Wenn die erste Polarisatorstellung wieder an der Reihe ist, addiert sich die Signalladung zu den schon vorhandenen Signalelektronen im ersten Subpixel. Dieser Zyklus wird so lange fortgesetzt, bis ausreichend Photonen gesammelt wurden oder der dynamische Bereich der DEPFETs ausgeschöpft ist. Besitzt der Modulator vier Stellungen, sind vier separate DEPFET-Speicher je Pixel notwendig, um die Bildintensitäten der vier Modulator-Stellungen zu speichern. Durch diese Methode wird erreicht, dass die vier Subpixel zeitlich eng korreliert mit Signalladungen gefüllt werden, so dass sich bei einer späteren Subtraktion der Bilder auch höherfrequente Störungen auslöschen.
Wie im ersten Ausführungsbeispiel ist es auch hier vorteilhaft, die Selektivität durch ein Zusammenlegen der Schirmelektroden benachbarter Subpixel über die Pixelgrenzen hinaus zu verbessern. Wenn man das in Figur 5 dargestellte Pixel in Bezug auf die Pixelgrenzen in beiden Richtungen gespiegelt verschaltet, erkennt man, dass sich die Flächen der zusammengelegten Schirmelektroden gegenüber der Fläche einer einzelnen subpixelbezogenen Schirmelektrode vervierfacht. Die Verschaltung der Pixel in einer Matrixanordnung wird in den Figuren 8 und 9A-9D gezeigt. Die vergrößerten Schirmelektroden rotieren beim Umschalten um die Pixel herum, wie durch die in den Figuren 9A-9D enthaltene Bildfolge illustriert wird.

Hierbei sind vier Steuerleitungen SLD1, SLD2, SLD3 und SLD4 dargestellt, wobei in sämtlichen Pixeln der Matrix die Drains der vier Subpixel jeweils mit einer der Steuerleitungen SLD1, SLD2, SLD3 und SLD4 verbunden sind.

Weiterhin weist jede Zeile der Matrix zwei Steuerleitungen SLG1i und SLG2i auf, um die gemeinsamen Gates von jeweils zwei Subpixeln der Pixel der jeweiligen Zeile anzusteuern.

Schließlich zeigt Figur 8 sechs Ausgangsleitungen O1-O6, die jeweils spaltenweise mit den gemeinsamen Sources der Subpixel der jeweiligen Spalte verbunden sind.

Die Signalauslese kann jeweils für diejenigen Subpixel erfolgen, die sich gerade im insensitiven Zustand befinden. Während Polarisatorstellung eins oder zwei können beispielsweise die Subpixel drei und vier ausgelesen werden, und umgekehrt. Das Auslesen einer Zeile benötigt normalerweise wesentlich weniger Zeit als das Sammeln; denn die Geschwindigkeit, mit der die Polarisatorstellung gewechselt werden kann, ist ausschlaggebend für die Dauer einer Sammelphase. In der Regel begrenzt das Wechseln der Polarisatorebene diese Integrationszeit. Daher können sogar mehrere Zeilen während einer Polarisatorstellung ausgelesen werden.

Nach einigen Zyklen ist daher die gesamte Matrix ausgelesen, ohne die Ladungssammlung der jeweils anderen DEPFETs zu unterbrechen. Dadurch kann auch hier eine Totzeit des Systems vermieden werden.

### Bezugszeichenliste

- 1: DEPFET
- 2: DEPFET
- 3: Siliziumwafer
- 4: Rückseitige Schicht des Siliziumwafers
- 5: Dielektrikum
- 6: Dielektrikum
- 7: Separator
- D: Drain
- D1, Dl': Drain
- D2, D2': Drain
- DS: Driftstruktur
- G1, G1': Externes Gate
- G2, G2': Externes Gate
- IG1: Internes Gate
- IG2: Internes Gate
- L, L': Löschstruktur
- S, S': Source
- S1: Source
- S2: Source
- SH1: Schirmelektrode
- SH2: Schirmelektrode
- SLD1: Steuerleitung für die Drains
- SLD2: Steuerleitung für die Drains
- SLD3: Steuerleitung für die Drains
- SLD4: Steuerleitung für die Drains
- SLG1i: Steuerleitung für die Gates
- SLG2i: Steuerleitung für die Gates
- O1-O6: Ausgangsleitungen
- V_{B}: Spannung an der rückseitigen Schicht 4 zur Verarmung des Siliziumwafers 3
- V_{S}: Potenzial der Source
- V_{G1}: Potenzial des externen Gates G1
- V_{G2}: Potenzial des externen Gates G2
- V_{S}: Potenzial der gemeinsamen Source S
- V_{S1}: Potenzial der Source S1
- V_{S2}: Potenzial der Source S2
- V_{D}: Potenzial des gemeinsamen Drains D
- V_{D1}: Potenzial des Drains D1
- V_{D1}: Potenzial des Drains D2

## Patentansprüche

1. Detektoranordnung zur Detektion von Strahlung, insbesondere von Teilchenstrahlung oder elektromagnetischer Strahlung, mit
a) einem Halbleiterdetektor mit mehreren Pixeln zur Detektion der Strahlung,
b) wobei die einzelnen Pixel jeweils ein erstes Subpixel (1) mit einem ersten DEPFET (1) mit einem internen Gate (IG1) zum Sammeln der strahlungsgenierten Signalladungsträger und ein zweites Subpixel (2) mit einem zweiten DEPFET (2) mit einem internen Gate (IG2) zum Sammeln der strahlungsgenerierten Signalladungsträger aufweisen, und
c) wobei der Halbleiterdetektor umschaltbar ist zwischen
c1) einem ersten Sammelzustand, in dem das erste Subpixel (1) sensitiv und das zweite Subpixel (2) insensitiv ist, so dass strahlungsgenerierte Signalladungsträger nur in dem ersten Subpixel (1) gesammelt werden, wobei in dem ersten Sammelzustand die strahlungsgenerierten Signalladungsträger im Wesentlichen nur in das interne Gate (IG1) des ersten DEPFETS (1) gelangen, wohingegen das interne Gate (IG2) des zweiten DEPFET (2) abgeschirmt ist, so dass im Wesentlichen keine der strahlungsgenerierten Signalladungsträger in das interne Gate (IG2) des zweiten DEPFET (2) gelangen, und
c2) einem zweiten Sammelzustand, in dem das zweite Subpixel (2) sensitiv und das erste Subpixel (1) insensitiv ist, so dass die strahlungsgenerierten Signalladungsträger nur in dem zweiten Subpixel (2) gesammelt werden, wobei in dem zweitem Sammelzustand die strahlungsgenerierten Signalladungsträger im Wesentlichen nur in das interne Gate (IG2) des zweiten DEPFETS (2) gelangen, wohingegen das interne Gate (IG1) des ersten DEPFET (1) abgeschirmt ist, so dass im Wesentlichen keine der strahlungsgenerierten Signalladungsträger in das interne Gate (IG1) des ersten DEPFET (1) gelangen,
d) wobei Schirmelektroden (SH1, SH2; D1, D2) vorgesehen sind zum Abschirmen des internen Gates (IG1, IG2) des DEPFETs (1, 2) in dem insensitiv geschalteten Subpixel, so dass die strahlungsgenerierten Signalladungsträger nicht in das interne Gate (IG1, IG2) des DEPFETs (1, 2) in dem insensitiv geschalteten Subpixel gelangen,
**dadurch gekennzeichnet,**
e) **dass** zur Erreichung einer hohen Selektivität der Abschirmwirkung der Schirmelektroden (SH1, SH2) folgendes vorgesehen ist:
e1) die Detektoranordnung beansprucht für ein Pixel eine bestimmte Gesamtpixelfläche eines Halbleitersubstrats, wobei die Schirmelektroden (SH1, SH2) einen Flächenanteil von mindestens 10% der Gesamtpixelfläche einnehmen, um die hohe Selektivität ihrer Abschirmwirkung zu erreichen, und/oder
e2) der laterale Abstand zwischen den internen Gates (IG1, IG2) der DEPFETs (1, 2) ist wesentlich kleiner als die laterale Ausdehnung der Schirmelektroden (SH1, SH2), um die hohe Selektivität ihrer Abschirmwirkung zu erreichen.

2. Detektoranordnung nach Anspruch 1, **dadurch gekennzeichnet, dass**
a) die DEPFETs (1, 2) der Subpixel eine gemeinsame Source (S) haben und die Drains (D1, D2) der DEPFETs (1, 2) die Schirmelektroden bilden, oder
b) die DEPFETs (1, 2) der Subpixel eine gemeinsame Drain (D) haben und die Sources (S1, S2) der DEPFETs (1, 2) die Schirmelektroden bilden, oder
c) die Schirmelektroden (SH1, SH2) von den Drains (D1, D2, D) und den Sources (S, Sl, S2) der DEPFETs (1, 2) getrennt und separat ansteuerbar sind.

3. Detektoranordnung nach einem der vorhergehenden Ansprüche, **dadurch gekennzeichnet,**
a) **dass** die Schirmelektroden mehrerer Pixel elektrisch miteinander verbunden sind, und/oder
b) **dass** die DEPFETs (1, 2) jeweils ein externes Gate (G1, G2) aufweisen und dass das externe Gate (G1, G2) des sensitiven DEPFETs (1, 2) anders angesteuert wird als das externe Gate (G1, G2) des insensitiven DEPFETs (1, 2), und die unterschiedliche Ansteuerung der externen Gates (G1, G2) der DEPFETs (1, 2) in dem Halbleiterdetektor zu einem Potentialfeld beiträgt, das die strahlungsgenerierten Signalladungsträger nur in das interne Gate des sensitiven DEPFETs leitet und das interne Gate des insensitiven DEPFETs abschirmt.

4. Detektoranordnung nach einem der vorhergehenden Ansprüche, **dadurch gekennzeichnet,**
a) **dass** die einzelnen Pixel jeweils mindestens vier Subpixel aufweisen, die dazu vorgesehen sind, sequentiell sensitiv geschaltet zu werden und ansonsten insensitiv zu sein, und/oder
b) **dass** die Subpixel auf einem gemeinsamen Substrat (3) angeordnet und durch einen Separator (7) voneinander getrennt sind, insbesondere durch einen Separator (7) aus Polysilizium.

5. Detektoranordnung nach einem der vorhergehenden Ansprüche, **dadurch gekennzeichnet, dass** die Pixel eine Driftstruktur (DS) enthalten, welche die strahlungsgenerierten Signalladungsträger zu den DEPFETs (1, 2) driften lässt.

6. Detektoranordnung nach einem der vorhergehenden Ansprüche, **dadurch gekennzeichnet, dass** alle Pixel der Matrix oder die Pixel der einzelnen Zeilen oder der einzelnen Spalten dazu vorgesehen sind, jeweils gemeinsam zwischen den verschiedenen Sammelzuständen umgeschaltet zu werden.

## Claims

1. Detector arrangement for detecting radiation, in particular particle radiation or electromagnetic radiation, with
a) a semiconductor detector with several pixels for detecting the radiation,
b) the individual pixels each having a first subpixel (1) having a first DEPFET (1) with an internal gate (IG1) for collecting the radiation-generated signal charge carriers and a second subpixel (2) having a second DEPFET (2) with an internal gate (IG2) for collecting the radiation-generated signal charge carriers, and
c) said semiconductor detector being switchable between
c1) a first collecting state in which the first subpixel (1) is sensitive and the second subpixel (2) is insensitive, so that radiation-generated signal charge carriers are collected only in the first subpixel (1), wherein in the first collecting state the radiation-generated signal charge carriers essentially only reach the internal gate (IG1) of the first DEPFET (1), whereas the internal gate (IG2) of the second DEPFET (2) is shielded so that substantially none of the radiation-generated signal charge carriers reach the internal gate (IG2) of the second DEPFET (2), and
c2) a second collecting state in which the second subpixel (2) is sensitive and the first subpixel (1) is insensitive, so that the radiation-generated signal carriers are collected only in the second subpixel (2), wherein in the second collecting state the radiation-generated signal charge carriers substantially only enter the internal gate (IG2) of the second DEPFET (2), whereas the internal gate (IG1) of the first DEPFET (1) is shielded so that substantially none of the radiation-generated signal charge carriers enter the internal gate (IG1) of the first DEPFET (1),
d) wherein shielding electrodes (SH1, SH2; D1, D2) are provided for shielding the internal gate (IG1, IG2) of the DEPFET (1, 2) in the subpixel being switched insensitive so that the radiation-generated signal charge carriers do not enter the internal gate (IG1, IG2) of the DEPFET (1, 2) in the subpixel being switched insensitive,
**characterized in that,**
e) the following is provided to achieve a high selectivity of the shielding effect of the shielding electrodes (SH1, SH2):
e1) the detector arrangement requires a certain total pixel area of a semiconductor substrate for one pixel, wherein the shielding electrodes (SH1, SH2) occupy an area fraction of at least 10% of the total pixel area in order to achieve the high selectivity of their shielding effect, and/or
e2) the lateral distance between the internal gates (IG1, IG2) of the DEPFETs (1, 2) is substantially smaller than the lateral extent of the shield electrodes (SH1, SH2) in order to achieve the high selectivity of their shielding effect.

2. Detector arrangement according to claim 1, **characterized in that**
a) the DEPFETs (1, 2) of the subpixels have a common source (S) and the drains (D1, D2) of the DEPFETs (1, 2) form the shielding electrodes, or
b) the DEPFETs (1, 2) of the subpixels have a common drain (D) and the sources (S1, S2) of the DEPFETs (1, 2) form the shielding electrodes, or
c) the shielding electrodes (SH1, SH2) are separate from the drains (D1, D2, D) and the sources (S, S1, S2) of the DEPFETs (1, 2) and can be controlled separately.

3. Detector arrangement according to one of the preceding claims, **characterized in that**
a) the shielding electrodes of several pixels are electrically connected to each other, and/or
b) the DEPFETs (1, 2) each comprise an external gate (G1, G2) and the external gate (G1, G2) of the sensitive DEPFET (1, 2) is driven differently from the external gate (G1, G2) of the insensitive DEPFET (1, 2), and the different drive of the external gates (G1, G2) of the DEPFETs (1, 2) in the semiconductor detector contributes to a potential field that conducts the radiation-generated signal charge carriers only into the internal gate of the sensitive DEPFET and shields the internal gate of the insensitive DEPFET.

4. Detector arrangement according to one of the preceding claims, **characterized in that**
a) the individual pixels each have at least four subpixels which are intended to be sequentially sensitive and otherwise insensitive, and/or
b) the subpixels are arranged on a common substrate (3) and separated from one another by a separator (7), in particular by a separator (7) made of polysilicon.

5. Detector arrangement according to one of the preceding claims, **characterized in that** the pixels contain a drift structure (DS) which allows the radiation-generated signal charge carriers to drift to the DEPFETs (1, 2).

6. Detector arrangement according to one of the preceding claims, **characterized in that** all pixels of the matrix or the pixels of the individual rows or the individual columns are provided to be switched in each case jointly between the different collecting states.

## Revendications

1. Ensemble détecteur servant à détecter un rayonnement, en particulier un rayonnement de particules ou un rayonnement électromagnétique, avec
a) un détecteur semi-conducteur avec plusieurs pixels servant à la détection du rayonnement,
b) dans lequel les divers pixels présentent un premier sous-pixel (1) avec un premier DEPFET [depleted field effect transistor - transistor à effet de champ appauvri] (1) avec une grille (IG1) interne servant à combiner les porteurs de charge de signal générés par rayonnement et un deuxième sous-pixel (2) avec un deuxième DEPFET (2) avec une grille (IG2) interne servant à combiner les porteurs de charge de signal générés par rayonnement, et
c) dans lequel le détecteur semi-conducteur peut être commuté entre
c1) un premier état combiné, dans lequel le premier sous-pixel (1) est sensible et le deuxième sous-pixel (2) est insensible, si bien que des porteurs de charge de signal générés par rayonnement sont combinés seulement dans le premier sous-pixel (1), dans lequel dans le premier état combiné, les porteurs de charge de signal générés par rayonnement parviennent sensiblement seulement dans la grille (IG1) interne du premier DEPFET (1), tandis que la grille (IG2) interne du deuxième DEPFET (2) est protégée si bien que sensiblement aucun des porteurs de charge de signal générés par rayonnement ne parvient dans la grille (IG2) interne du deuxième DEPFET (2), et
c2) un deuxième état combiné, dans lequel le deuxième sous-pixel (2) est sensible et le premier sous-pixel (1) est insensible si bien que les porteurs de charge de signal générés par rayonnement sont combinés seulement dans le deuxième sous-pixel (2), dans lequel dans le deuxième état combiné, les porteurs de charge de signal générés par rayonnement parviennent sensiblement seulement dans la grille (IG2) interne du deuxième DEPFET (2), tandis que la grille (IG1) interne du premier DEPFET (1) est protégée si bien que sensiblement aucun des porteurs de charge de signal générés par rayonnement ne parvient dans la grille (IG1) interne du premier DEPFET (1),
d) dans lequel des électrodes de protection (SH1, SH2 ; D1, D2) sont prévues pour protéger la grille (IG1, IG2) interne du DEPFET (1, 2) dans le sous-pixel commuté de manière insensible si bien que les porteurs de charge de signal générés par rayonnement ne parviennent pas dans la grille (IG1, IG2) interne du DEPFET (1, 2) dans le sous-pixel commuté de manière insensible,
**caractérisé en ce**
e) **qu'**est prévu pour atteindre une sélectivité élevée de l'effet de protection des électrodes de protection (SH1, SH2), ce qui suit :
e1) l'ensemble détecteur requiert pour un pixel une surface de pixel totale définie d'un substrat semi-conducteur, dans lequel les électrodes de protection (SH1, SH2) adoptent une partie de surface d'au moins 10 % de la surface de pixel totale afin d'atteindre la sélectivité élevée de leur effet de protection, et/ou
e2) la distance latérale entre les grilles (IG1, IG2) internes des DEPFET (1, 2) est sensiblement plus petite que l'extension latérale des électrodes de protection (SH1, SH2) afin d'atteindre la sélectivité élevée de leur effet de protection.

2. Ensemble détecteur selon la revendication 1, **caractérisé en ce que**
a) les DEPFET (1, 2) des sous-pixels ont une source (S) commune et les drains (D1, D2) des DEPFET (1, 2) forment les électrodes de protection, ou
b) les DEPFET (1, 2) des sous-pixels ont un drain (D) commun et les sources (S1, S2) des DEPFET (1, 2) forment les électrodes de protection, ou
c) les électrodes de protection (SH1, SH2) peuvent être pilotées de manière divisée et séparée des drains (D1, D2, D) et des sources (S, S1, S2) des DEPFET (1, 2) .

3. Ensemble détecteur selon l'une quelconque des revendications précédentes, **caractérisé en ce**
a) **que** les électrodes de protection de plusieurs pixels sont reliées de manière électrique les unes aux autres, et/ou
b) **que** les DEPFET (1, 2) présentent respectivement une grille (G1, G2) externe et que la grille (G1, G2) externe du DEPFET (1, 2) sensible est pilotée autrement que la grille (G1, G2) externe du DEPFET (1, 2) insensible, et le pilotage différent de la grille (G1, G2) externe des DEPFET (1, 2) dans le détecteur semi-conducteur contribue à un champ de potentiel, qui guide les porteurs de charge de signal générés par rayonnement seulement dans la grille interne du DEPFET sensible et protège la grille interne du DEPFET insensible.

4. Ensemble détecteur selon l'une quelconque des revendications précédentes, **caractérisé en ce**
a) **que** les divers pixels présentent respectivement au moins quatre sous-pixels, qui sont prévus pour être commutés séquentiellement de manière sensible et pour être par ailleurs insensibles, et/ou
b) **que** les sous-pixels sont disposés sur un substrat (3) commun et sont séparés les uns des autres par un séparateur (7), en particulier par un séparateur (7) composé de polysilicium.

5. Ensemble détecteur selon l'une quelconque des revendications précédentes, **caractérisé en ce que** les pixels contiennent une structure de dérivation (DS), laquelle fait dériver les porteurs de charge de signal générés par rayonnement vers les DEPFET (1, 2).

6. Ensemble détecteur selon l'une quelconque des revendications précédentes, **caractérisé en ce que** tous les pixels de la matrice ou les pixels des diverses lignes ou des diverses colonnes sont prévus pour être commutés respectivement ensemble entre les divers états combinés.
